# EUROPEAN PATENT SPECIFICATION

(11) **EP 4 388 753 B1**
(45) Date of publication and mention of the grant of the patent: **25.03.2026**
(21) Application number: 22762239.6
(22) Date of filing: 09.08.2022
(51) Int. Cl.: H04R 27/00, H03G 3/10, G06F 3/16

(54) **SYSTEM FOR CONTROLLING VOLUME LEVELS OF A PLURALITY OF SPEAKERS AND METHOD THEREFOR**
SYSTEM ZUM STEUERN VON LAUTSTÄRKEPEGELN MEHRERER LAUTSPRECHER UND VERFAHREN DAFÜR
SYSTEME DE COMMANDE DES NIVEAUX DE VOLUME D'UNE PLURALITE DE HAUT-PARLEURS ET PROCEDE ASSOCIE

(30) Priority: 17.08.2021 US 202163234181 P
(43) Date of publication of application: 26.06.2024
(73) Proprietor: DTS, Inc., Calabasas, CA 91302 (US)
(72) Inventor: LAU, Dannie, Los Angeles, California 90064 (US); O'BRIEN, Darren, Calabasas, California 91302 (US)
(74) Representative: Müller, Wolfram Hubertus
(86) International application number: PCT/US2022/074715
(87) International publication number: WO 2023/023457

(56) References cited:
- US-A1- 2017 031 648
- US-A1- 2019 007 232

## Description

### FIELD OF THE DISCLOSURE

The present disclosure relates to controlling volume levels of a plurality of speakers.

### BACKGROUND OF THE DISCLOSURE

There is ongoing effort to improve systems and methods for controlling volume levels of a plurality of speakers.

Document US 2017/031648 A1 discloses a sound output system comprising a plurality of speaker apparatuses and a user terminal apparatus. The speaker apparatuses output a sound source content stored in an external cloud server. Each of the speaker apparatuses provides device information to the user terminal apparatus and receives a sound volume adjusting command from the user terminal apparatus and outputs sound source content with a sound volume adjusted according to the received sound volume adjusting command.

Document US 2019/007232 A1 discloses inter-device control operations that include a media rendering device such as a TV and bluetooth speakers.

### SUMMARY

The present invention provides for a system for controlling volume levels of a plurality of speakers with the features of claim 1, a method for controlling volume levels of a plurality of speakers with the features of claim 9 and a system for controlling volume levels of a plurality of speakers with the features of claim 13. Embodiments of the invention are identified in the dependent claims.

### BRIEF DESCRIPTION OF THE DRAWINGS

FIG. 1 shows a block diagram of an example of a system for controlling volume levels of a plurality of speakers.
FIG. 2 shows a flow chart of an example of a method for controlling volume levels of a plurality of speakers.
FIG. 3 shows an example of an image, including a speaker volume selector, displayed on a display screen for a system for controlling volume levels of a plurality of speakers, for a selected volume level that is "moderate".
FIG. 4 shows an example of an image, including a speaker volume selector, displayed on a display screen for a system for controlling volume levels of a plurality of speakers, for a selected volume level that is "loud".
FIG. 5 shows an example of an image, including a speaker volume selector, displayed on a display screen for a system for controlling volume levels of a plurality of speakers, for a selected volume level that is "quiet".
FIG. 6 shows an example of an image, including a speaker volume selector, displayed on a display screen for a system for controlling volume levels of a plurality of speakers, for a selected volume level of zero.

Corresponding reference characters indicate corresponding parts throughout the several views. Elements in the drawings are not necessarily drawn to scale. The configurations shown in the drawings are merely examples and should not be construed as limiting in any manner.

### DETAILED DESCRIPTION

In multi-speaker systems, such as audio-visual systems or systems that play audio simultaneously through speakers in different rooms, a single volume controller can raise and lower the volumes of the speakers simultaneously. For example, a remote control associated with a television can raise and lower a volume of the television speaker or speakers along with automatically raising and lowering the volumes of separate side speakers and/or separate surround sound speakers.

Different speaker manufacturers and/or different speaker models may produce different sound pressure levels for a comparable volume level. To accommodate different speaker manufacturers and/or different speaker models in a single audio or audio-visual system, and/or relative placements of the speakers with respect to a particular listening location, a volume controller can include programmable offsets associated with the speakers. For example, the volume controller can allow a user to select an offset of 20 volume units for a second speaker with respect to a first speaker or with respect to a volume selector. Such an offset will instruct the volume controller to boost the volume of the second speaker by 20 volume units with respect to the volume of the first speaker or the selected system volume. In some examples, the offsets can be set by selecting one of a specified number of volume levels, such as by stepping through a range of allowable offsets. In some examples, the step amounts can be the same for all the speakers. Once the offset has been set, the offset can be considered to be fixed during normal operation. During normal operation, the user can select a volume level (such as by raising or lowering a current volume level) from the volume controller. In response to the selected volume level, the volume controller can raise and lower the volumes of the first and second speakers, together, using the selected offset. For example, a user can select a volume level of 13, which can automatically set the volume of the first speaker to 13 and set the volume of the second speaker to 33. The user can raise the volume level to 18, which can automatically set the volume of the first speaker to 18 and set the volume of the second speaker to 38.

Using selectable volume offsets in this manner can lead to situations in which the volume controller specifies a volume level that exceeds a maximum volume level of a speaker. For example, in response to hearing a favorite song, a user may select a maximum volume level of 100 on the volume controller. The volume controller can set the volume of the first speaker to 100, which can coincide with a maximum volume of the first speaker. If the selectable volume offset of 20 were applied unconditionally, the volume controller would attempt to set the volume of the second speaker to 120, which would exceed the maximum volume of the second speaker. Further, if the volume controller were to merely limit the volume of the second speaker to 100, when the song ends and the user brings down the volume, the volume controller might bring down the volumes of the first and second speakers, together, and might lose the relationship specified by the selected offset of 20. Similarly, a situation might arise in which unconditional use of the selectable or specified volume offset would cause the volume controller to set the volume of a speaker below a zero level or a minimum non-zero volume level.

To maintain a specified offset among speakers while operating the speakers in their allowable range of volume levels, a system can control volume levels of a plurality of speakers as discussed in detail below.

In an example, a system controls volume levels of a plurality of speakers. The system receives a selected volume level. The system receives a plurality of volume offsets corresponding to the plurality of speakers. At least two volume offsets are different from each other. The system calculates provisional volume levels for the plurality of speakers. Each provisional volume level is a sum of the selected volume level and the corresponding volume offset of the speaker. When the provisional volume level of a speaker is within an operational range of volume levels for the speaker, the system sets a volume level of the speaker to equal the provisional volume level. When the provisional volume level is outside the operational range of volume levels for the speaker, the system sets the volume level of the speaker to equal a value within the operational range of volume levels for the speaker, such as a minimum nonzero volume level of the speaker or a maximum volume level of the speaker.

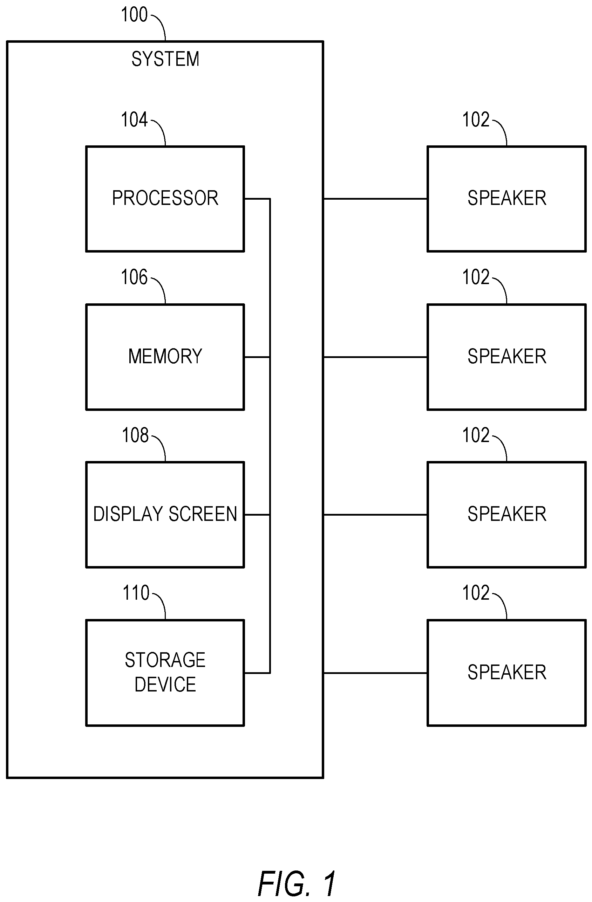

FIG. 1 shows a block diagram of an example of a system 100 for controlling volume levels of a plurality of speakers 102. The configuration of FIG. 1 is but one example of such a system 100; other configurations can also be used.

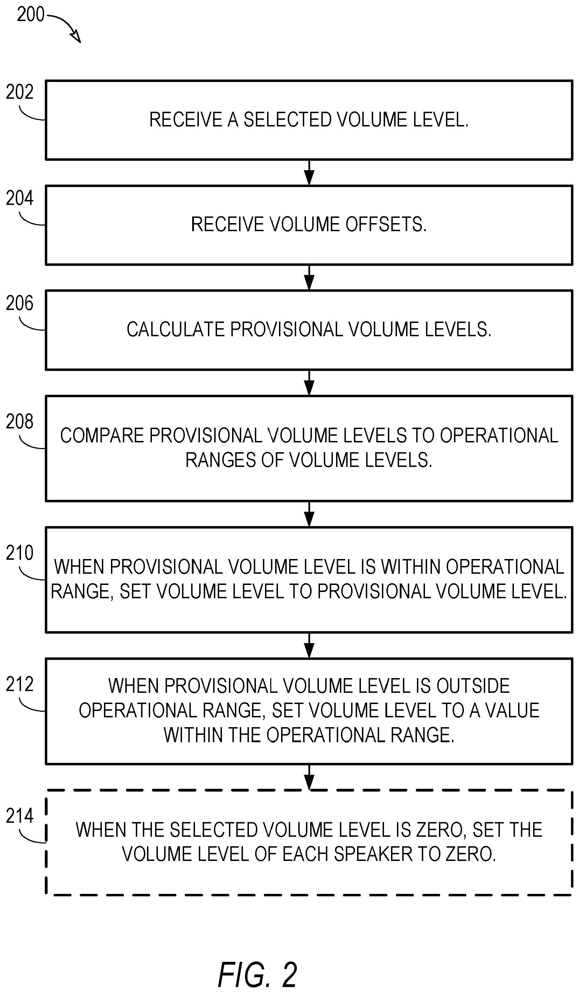

The system 100 includes a processor 104. Memory 106 can store instructions that, when executed by the processor 104, cause the processor 104 to execute operations. The operations are detailed below and shown in FIG. 2. The system 100 can provide an electronic display screen 108 coupled to the processor 104. For example, the system 100 can generate a video signal, such as a display screen 108 that can be displayed on a television or a video monitor. The instructions can cause the processor 104 to produce a display of images on the display screen 108 to indicate volume levels of multiple speakers. The screen can show graphical and/or numerical values of volume levels for the various speakers 102. The display screen 108 can allow a user to change the volume levels of all or some of the speakers 102 by changing or selecting a single volume level. For example, a display screen 108 that includes a remote control can include a "volume up" button and a "volume down" button on the remote control, which can increment or decrement a current volume level by a specified volume increment. As another example, a display screen 108 that includes a screen can include graphical or numerical features that can be selected or can receive input that specifies a selected volume level. The processor 104 can receive a selected volume level through the display screen 108. The processor 104 can retain the selected volume level in memory 106, such as random-access memory or written to a storage device locally or accessible through a server. The processor 104 can retrieve volume offsets (discussed in detail below) from a storage device 110, such as a local storage device or a storage device 110 that is accessible through a wired or wireless connection to a server.

The system 100 can be coupled to, but may not necessarily include, various speakers 102. For example, the system 100 may include speakers 102 such as television speakers, sound bars, stereo Bluetooth speakers, network speakers, laptop device, mobile devices, and others. The speakers 102 can be located in a single room or can be located in various rooms throughout a house or building. One or more of the speakers 102 can receive an audio signal as a digital input, such as via a wired or wireless connection, such as a WiFi connection. Further, a speaker 102 can receive digital data that determines a volume level for the speaker 102. The digital data can be included with the audio signal and can be separate from the audio signal. In some examples, one or more of the speakers 102 can receive the audio signal as an analog input, such as via a wired connection, and can receive digital data that determines the volume level for the speaker 102.

The processor 104 can be coupled to the plurality of speakers 102. In some examples, the processor 104 can supply the digital data to the plurality of speakers 102. For speakers 102 that receive analog inputs, the processor 104 can supply analog signals, such as time-varying voltages or currents, to the speakers 102.

The processor 104 receives, saves, and retrieves data that represents volume offsets for the various speakers 102 that are coupled to the system 100. For example, the data can include the volume offsets, or can include provisional volume levels that are a sum of the selected volume level and the respective volume levels. The volume offsets can represent a difference between a selected volume level (e.g., a value selected by a user using a volume control on the display screen 108) and an actual volume level of a speaker 102. The volume offsets can compensate for differences in speaker manufacturers, speaker models, speaker placement, and other factors that can cause imbalance of the sound levels. As a user adjusts a volume of the system 100, the offsets can remain in place, so that the speaker volumes can rise and fall together during volume adjustment. Volume offsets can also be negative or zero. In some examples, the volume offsets can be set when a system 100 is assembled or calibrated. In some examples, the volume offsets may not be adjusted in day-today use of the system 100. During normal use of the system 100, the volume offsets can be retrieved from memory 106 or a storage device 110 that stores the volume offsets locally or via a wired or wireless server.

The processor 104 performs calculations to determine the volume levels of the speakers 102. For many cases, in which the selected volume level and the volume offset combine such that the resulting volume level is near the middle of the operational range of volume levels, the calculation includes summing the selected volume level and the volume offset. However, some cases could cause problems for the speakers 102, such as when the sum of the selected volume level and the volume offset would be outside the operational range of volume levels. The processor 104 performs calculations to account for these cases. The remainder of this document explains such calculations in detail.

FIG. 2 shows a flow chart of an example of a method 200 for controlling volume levels of a plurality of speakers, such as speakers 102. The method can be executed by the system 100 of FIG. 1, or by another suitable system.

At operation 202, the system receives a selected volume level, such as from a user interface. In some examples, the user interface can include images displayed on a display screen, such as on a television or video monitor. In some examples, the system can receive digital volume selection data from the user interface. The digital volume selection data can represent the selected volume level. The selected volume level can be one of a finite number of allowable volume levels selectable from the user interface. For example, the user interface can allow a user to select one of a specified (e.g., finite) number of volume levels. For example, the user interface can allow a user to select a volume level corresponding to an integer between zero (corresponding to silence) and 100. In some examples, the user interface can allow the selection of the selected volume level by allowing adjustment of a volume level by a volume step size. It will be understood that the use of a numerical scale between 0 and 100 is but one example of a scale suitable for volume control; other numerical or nonnumerical (e.g., graphical) volume scales can also be used.

At operation 204, the system receives a plurality of volume offsets corresponding to the plurality of speakers. In some examples, a volume offset for at least one speaker of the plurality of speakers is a positive quantity. In some examples, a volume offset for at least one speaker of the plurality of speakers is a negative quantity. In some examples, a volume offset for at least one speaker of the plurality of speakers is zero. In some examples, the system can retrieve digital volume offset data from a storage medium. The digital volume offset data can represent the plurality of volume offsets corresponding to the plurality of speakers. Each volume offset can be one of the finite number of allowable volume levels selectable from the user interface. In some examples, the plurality of volume offsets can include volume levels that differ by an integral multiple of the volume step size. The volume offsets can be independent of the selected volume level. At least two volume offsets of the plurality of volume offsets are different from each other.

At operation 206, for each speaker of the plurality of speakers, when the selected volume level is greater than zero, the system calculates a provisional volume level for the speaker as being a sum of the selected volume level and the volume offset of the speaker.

At operation 208, for each speaker of the plurality of speakers, when the selected volume level is greater than zero, the system compares the provisional volume level of the speaker to an operational range of volume levels for the speaker. In some examples, the operational range of volume levels of a speaker can extend between a minimum nonzero volume level of the speaker and a maximum volume level of the speaker, inclusive. For example, for selectable volume levels that include integers between 0 and 100, inclusive, the minimum nonzero volume level can be 1, the maximum volume level can be 100, and the operational range of volume levels can extend from 1 to 100, inclusive.

At operation 210, for each speaker of the plurality of speakers, when the selected volume level is greater than zero, when the provisional volume level of the speaker is within the operational range of volume levels for the speaker, the system sets a volume level of the speaker to equal the provisional volume level of the speaker.

At operation 212, for each speaker of the plurality of speakers, when the selected volume level is greater than zero, when the provisional volume level of the speaker is outside the operational range of volume levels for the speaker, the system sets the volume level of the speaker to equal a value within the operational range of volume levels for the speaker. When the provisional volume level of the speaker is greater than the maximum volume level of the speaker, the system sets the volume level of the speaker to equal the maximum volume level of the speaker. When the provisional volume level of the speaker is less than the minimum nonzero volume level of the speaker, the system sets the volume level of the speaker to equal the minimum nonzero volume level of the speaker.

In some examples, as part of operation 212, the system can generate a digital volume signal that includes information corresponding to the volume level of the speaker, and sending the digital volume signal to the speaker.

In some examples, as part of operation 212, the system can display the volume levels of the speakers on the user interface.

At optional operation 214, when the selected volume level is zero, the system can set the volume level of each speaker of the plurality of speakers to equal zero.

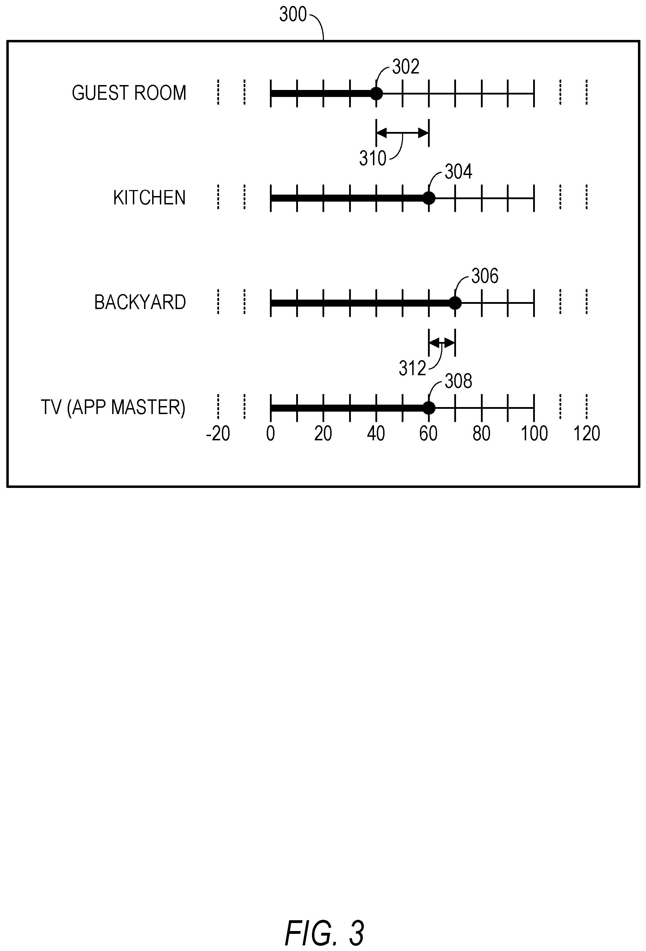

FIGS. 3-6 show examples of images displayed on a display screen showing four different selected volume levels, for the system of FIG. 1. The display screens of FIGS. 3-6 are merely examples; other suitable display screens or non-graphical user interfaces (e.g., such as for a remote control with volume up and volume down buttons) can also be used.

In the following discussion, the terms "quiet," "moderate," and "loud," are intended merely to imply relative volume levels, such that a "loud" volume level is greater than a "moderate" volume level, which in turn is greater than a "quiet" volume level. These terms are used merely for convenience, and do not denote absolute volume levels.

FIG. 3 shows an example of an image, including a speaker volume selector, displayed on a display screen 300 for a system for controlling volume levels of a plurality of speakers, for a selected volume level that is "moderate".

The display screen 300 shows four sets of volume levels. The display screen 300 depicts the volume levels as horizontal lines with lengths corresponding to the volume levels. A circular dot appears at the rightmost edge of the horizontal line, at the corresponding volume level. On an actual display screen 300, the scale of the volume levels would coincide with the operational range of volume levels of the speakers, such as from 0 to 100. For ease of explanation, FIG. 3 shows the scale as extending beyond the operational range of volume levels of the speakers, such as from -20 to +120. Other suitable ways to communicate the volume levels can also be used.

The three topmost volume levels 302, 304, and 306 correspond to speakers in a guest room, a kitchen, and a backyard, respectively. The bottommost volume level 308 corresponds to a speaker in a television (TV). The TV volume level 308 is directly adjustable or selectable by the user and can be referred to as a master volume control. Adjusting the TV volume level can automatically adjust all four volume levels simultaneously, or sequentially with relatively short delays between the adjustments. In other configurations, the master volume control may be displayed separately, rather than shown with a speaker and directly controlling a speaker. In some examples, the graphical user input 300 can receive input from a user device, such as a remote control or a smart phone. A user can enter a volume selection through the user device, such as through volume up and volume down buttons, or through the smart phone, such as through buttons, a slidable element, and/or direct numerical entry on the screen of the smart phone.

In the specific example of FIG. 3, the TV volume 308 is set to 60. The guest room speaker volume level 302 is set to 40. The guest room speaker has a volume offset 310 of -20. The kitchen speaker volume level 304 is set to 60. The kitchen speaker has a volume offset of zero. The backyard speaker volume level 312 of 70. The backyard speaker has a volume offset 312 of +10.

During typical operation of the audio system for "moderate" volumes, the volume offsets 310, 312 remain constant as the user adjusts the TV volume 308. For example, when the user raises the TV volume 308 by 5 to 65, the guest room speaker volume level 302 increases to 45, the kitchen speaker volume level 304 increases to 65, and the backyard speaker volume level 312 increases to 75.

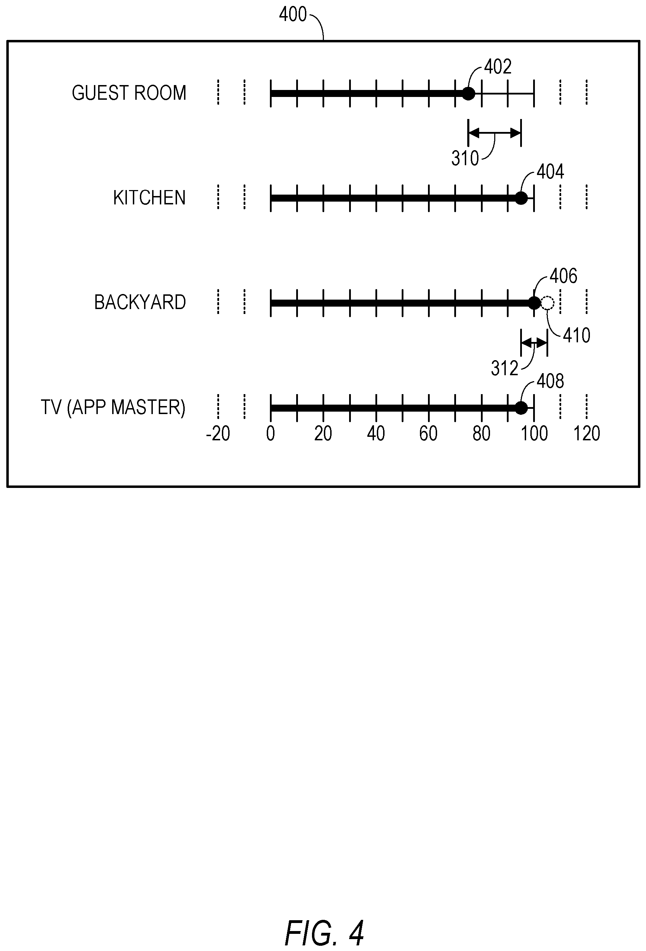

For "loud" or "quiet" volume levels, the audio system can modify volume levels to avoid setting any of the speaker volume levels to a value that is outside the operational range of volume levels for the speaker. FIGS. 4-6 show examples of these modifications.

FIG. 4 shows an example of an image, including a speaker volume selector, displayed on a display screen 400 for a system for controlling volume levels of a plurality of speakers, for a selected volume level that is "loud". Compared to FIG. 3, a user has raised the TV speaker volume level 408 by 35 units, from 60 in FIG. 3 to 95 in FIG. 4.

In response to the user's raising of the TV speaker volume level 408, the audio system has raised the guest room speaker volume level 402 by 35 to 75 and has raised the kitchen speaker volume level 404 by 35 to 95. The volume levels of 35 and 75 are within the operational range of volume levels for the guest room and kitchen speakers.

Raising the backyard speaker volume level by 35 would increase the backyard speaker volume level to 105, which is outside the operational range of volume levels for the backyard speaker. The value of 105 may be considered to be a provisional volume level 410. The audio system determines that the provisional volume level 410 is greater than the maximum volume level of the backyard speaker (such as by following the method 200) and sets the backyard speaker volume level 406 to 100, which is the maximum volume level of the backyard speaker.

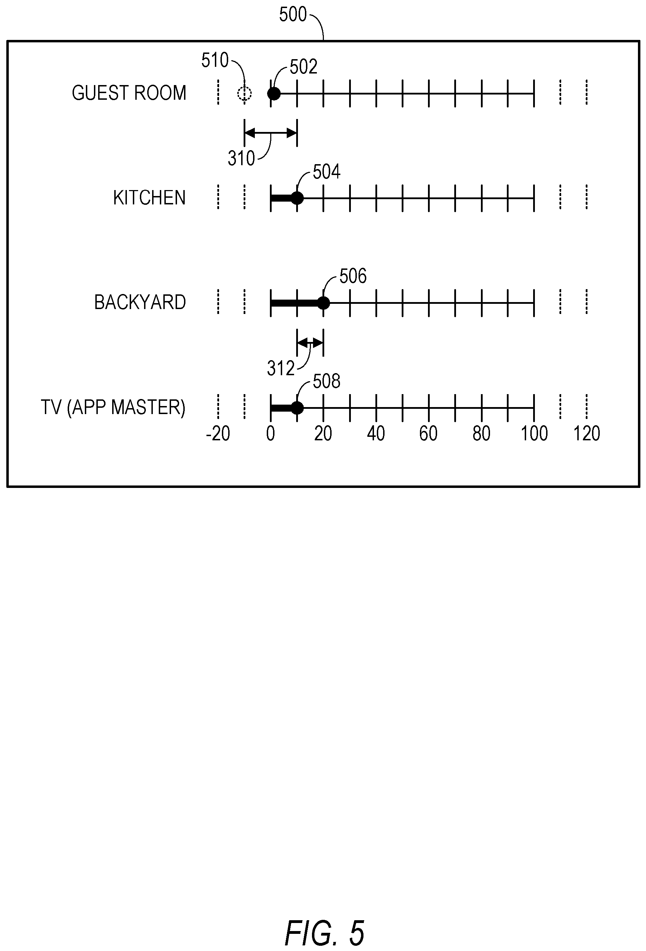

FIG. 5 shows an example of an image, including a speaker volume selector, displayed on a display screen 500 for a system for controlling volume levels of a plurality of speakers, for a selected volume level that is "quiet". Compared to FIG. 3, a user has lowered the TV speaker volume level 508 by 50 units, from 60 in FIG. 3 to 10 in FIG. 5.

In response to the user's lowering of the TV speaker volume level 508, the audio system has lowered the kitchen speaker volume level 504 by 50 to 10 and has lowered the backyard speaker volume level 506 by 50 to 20. The volume levels of 10 and 20 are within the operational range of volume levels for the kitchen and backyard speakers.

Lowering the guest room speaker volume level by 50 would decrease the guest room speaker volume level to -10, which is outside the operational range of volume levels for the guest room speaker. The value of -10 may be considered to be a provisional volume level 510. The audio system determines that the provisional volume level 510 is less than the minimum nonzero volume level of the guest room speaker (such as by following the method 200) and sets the guest room speaker volume level 502 to 1, which is the minimum nonzero volume level of the guest room speaker.

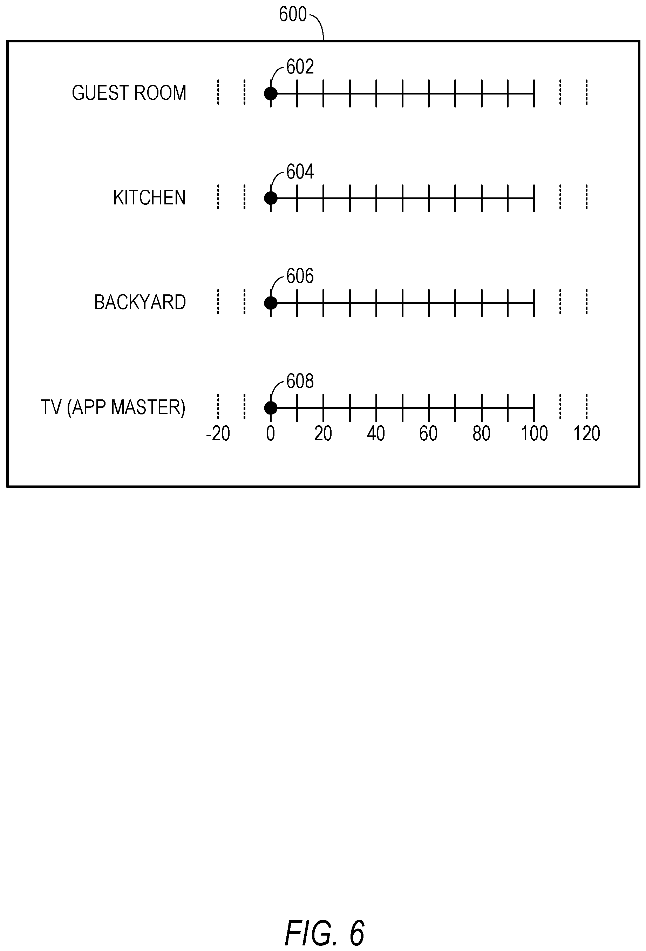

FIG. 6 shows an example of an image, including a speaker volume selector, displayed on a display screen 600 for a system for controlling volume levels of a plurality of speakers, for a selected volume level of zero.

Setting the TV speaker volume level 608 to zero can function like a mute button for the audio system. In response to receiving a selected volume level of zero, the system can set the levels of all the speakers to zero. For example, in response to a user setting the TV speaker volume level 608 to zero, the system can set the guest room speaker volume level 602 to zero, set the kitchen speaker volume level 604 to zero, and set the backyard speaker volume level 606 to zero.

Many other variations than those described herein will be apparent from this document. For example, depending on the embodiment, certain acts, events, or functions of any of the methods and algorithms described herein can be performed in a different sequence, can be added, merged, or left out altogether (such that not all described acts or events are necessary for the practice of the methods and algorithms). Moreover, in certain embodiments, acts or events can be performed concurrently, such as through multi -threaded processing, interrupt processing, or multiple processors or processor cores or on other parallel architectures, rather than sequentially. In addition, different tasks or processes can be performed by different machines and computing systems that can function together.

The various illustrative logical blocks, modules, methods, and algorithm processes and sequences described in connection with the embodiments disclosed herein can be implemented as electronic hardware, computer software, or combinations of both. To clearly illustrate this interchangeability of hardware and software, various illustrative components, blocks, modules, and process actions have been described above generally in terms of their functionality. Whether such functionality is implemented as hardware or software depends upon the particular application and design constraints imposed on the overall system. The described functionality can be implemented in varying ways for each particular application, but such implementation decisions should not be interpreted as causing a departure from the scope of the invention as it is defined in the appended claims.

The various illustrative logical blocks and modules described in connection with the embodiments disclosed herein can be implemented or performed by a machine, such as a general purpose processor, a processing device, a computing device having one or more processing devices, a digital signal processor (DSP), an application specific integrated circuit (ASIC), a field programmable gate array (FPGA) or other programmable logic device, discrete gate or transistor logic, discrete hardware components, or any combination thereof designed to perform the functions described herein. A general-purpose processor and processing device can be a microprocessor, but in the alternative, the processor can be a controller, microcontroller, or state machine, combinations of the same, or the like. A processor can also be implemented as a combination of computing devices, such as a combination of a DSP and a microprocessor, a plurality of microprocessors, one or more microprocessors in conjunction with a DSP core, or any other such configuration.

Embodiments of the television volume control system and method described herein are operational within numerous types of general purpose or special purpose computing system environments or configurations. In general, a computing environment can include any type of computer system, including, but not limited to, a computer system based on one or more microprocessors, a mainframe computer, a digital signal processor, a portable computing device, a personal organizer, a device controller, a computational ngine within an appliance, a mobile phone, a desktop computer, a mobile computer, a tablet computer, a smartphone, and appliances with an embedded computer, to name a few.

Such computing devices can typically be found in devices having at least some minimum computational capability, including, but not limited to, personal computers, server computers, hand-held computing devices, laptop or mobile computers, communications devices such as cell phones and PDA's, multiprocessor systems, microprocessor-based systems, set top boxes, programmable consumer electronics, network PCs, minicomputers, mainframe computers, audio or video media players, and so forth. In some embodiments the computing devices will include one or more processors. Each processor may be a specialized microprocessor, such as a digital signal processor (DSP), a very long instruction word (VLIW), or other micro-controller, or can be conventional central processing units (CPUs) having one or more processing cores, including specialized graphics processing unit (GPU)-based cores in a multi-core CPU.

The process actions or operations of a method, process, or algorithm described in connection with the embodiments disclosed herein can be embodied directly in hardware, in a software module executed by a processor, or in any combination of the two. The software module can be contained in computer-readable media that can be accessed by a computing device. The computer-readable media includes both volatile and nonvolatile media that is either removable, non-removable, or some combination thereof. The computer-readable media is used to store information such as computer-readable or computer-executable instructions, data structures, program modules, or other data. By way of example, and not limitation, computer readable media may comprise computer storage media and communication media.

Computer storage media includes, but is not limited to, computer or machine readable media or storage devices such as Bluray discs (BD), digital versatile discs (DVDs), compact discs (CDs), floppy disks, tape drives, hard drives, optical drives, solid state memory devices, RAM memory, ROM memory, EPROM memory, EEPROM memory, flash memory or other memory technology, magnetic cassettes, magnetic tapes, magnetic disk storage, or other magnetic storage devices, or any other device which can be used to store the desired information and which can be accessed by one or more computing devices.

A software module can reside in the RAM memory, flash memory, ROM memory, EPROM memory, EEPROM memory, registers, hard disk, a removable disk, a CD-ROM, or any other form of non-transitory computer-readable storage medium, media, or physical computer storage known in the art. An exemplary storage medium can be coupled to the processor such that the processor can read information from, and write information to, the storage medium. In the alternative, the storage medium can be integral to the processor. The processor and the storage medium can reside in an application specific integrated circuit (ASIC). The ASIC can reside in a user terminal. Alternatively, the processor and the storage medium can reside as discrete components in a user terminal.

The phrase "non-transitory" as used in this document means "enduring or long-lived". The phrase "non-transitory computer-readable media" includes any and all computer-readable media, with the sole exception of a transitory, propagating signal. This includes, by way of example and not limitation, non-transitory computer-readable media such as register memory, processor cache and random-access memory (RAM).

The phrase "audio signal" is a signal that is representative of a physical sound.

Retention of information such as computer-readable or computerexecutable instructions, data structures, program modules, and so forth, can also be accomplished by using a variety of the communication media to encode one or more modulated data signals, electromagnetic waves (such as carrier waves), or other transport mechanisms or communications protocols, and includes any wired or wireless information delivery mechanism. In general, these communication media refer to a signal that has one or more of its characteristics set or changed in such a manner as to encode information or instructions in the signal. For example, communication media includes wired media such as a wired network or direct-wired connection carrying one or more modulated data signals, and wireless media such as acoustic, radio frequency (RF), infrared, laser, and other wireless media for transmitting, receiving, or both, one or more modulated data signals or electromagnetic waves. Combinations of the any of the above should also be included within the scope of communication media.

Further, one or any combination of software, programs, computer program products that embody some or all of the various embodiments of the television volume control system and method described herein, or portions thereof, may be stored, received, transmitted, or read from any desired combination of computer or machine-readable media or storage devices and communication media in the form of computer executable instructions or other data structures.

Embodiments of the television volume control system and method described herein may be further described in the general context of computerexecutable instructions, such as program modules, being executed by a computing device. Generally, program modules include routines, programs, objects, components, data structures, and so forth, which perform particular tasks or implement particular abstract data types. The embodiments described herein may also be practiced in distributed computing environments where tasks are performed by one or more remote processing devices, or within a cloud of one or more devices, that are linked through one or more communications networks. In a distributed computing environment, program modules may be located in both local and remote computer storage media including media storage devices. Still further, the aforementioned instructions may be implemented, in part or in whole, as hardware logic circuits, which may or may not include a processor.

Conditional language used herein, such as, among others, "can," "might," "may," "e.g.," and the like, unless specifically stated otherwise, or otherwise understood within the context as used, is generally intended to convey that certain embodiments include, while other embodiments do not include, certain features, elements and/or states. Thus, such conditional language is not generally intended to imply that features, elements and/or states are in any way required for one or more embodiments or that one or more embodiments necessarily include logic for deciding, with or without author input or prompting, whether these features, elements and/or states are included or are to be performed in any particular embodiment. The terms "comprising," "including," "having," and the like are synonymous and are used inclusively, in an open-ended fashion, and do not exclude additional elements, features, acts, operations, and so forth. Also, the term "or" is used in its inclusive sense (and not in its exclusive sense) so that when used, for example, to connect a list of elements, the term "or" means one, some, or all of the elements in the list.

While the above detailed description has shown, described, and pointed out novel features as applied to various embodiments, it will be understood that various omissions, substitutions, and changes in the form and details of the devices or algorithms illustrated can be made without departing from the scope of the following claims.

## Claims

1. A system (100) for controlling volume levels of a plurality of speakers (102), the system comprising:
a processor (104); and
memory (106) configured to store instructions that, when executed by the processor, cause the processor to execute operations, the operations comprising:
displaying, on an electronic display screen (108), a speaker volume selector to receive input to select a volume level to set volume levels of the plurality of speakers (102);
receiving (204) a plurality of volume offsets corresponding to the plurality of speakers (102), at least two volume offsets of the plurality of volume offsets being different from each other;
in response to receiving the selected volume level at the speaker volume selector, for each speaker (102) of the plurality of speakers, when the selected volume level is greater than zero:
calculating (206) a provisional volume level for the speaker as being a sum of the selected volume level and the volume offset of the speaker;
comparing (208) the provisional volume level of the speaker to an operational range of volume levels for the speaker;
when the provisional volume level of the speaker is within the operational range of volume levels for the speaker, setting (210) a volume level of the speaker to equal the provisional volume level of the speaker; and
when the provisional volume level of the speaker is outside the operational range of volume levels for the speaker, setting (212) the volume level of the speaker to equal a value within the operational range of volume levels for the speaker; and
displaying, on the electronic display screen (108), the volume levels set for each of the speakers (102),
wherein the operational range of volume levels for the speaker (102) extends between a minimum nonzero volume level of the speaker and a maximum volume level of the speaker, inclusive, and
wherein the operations further comprise, for each speaker (102) of the plurality of speakers, when the selected volume level is greater than zero:
when the provisional volume level of the speaker is greater than the maximum volume level of the speaker, setting the volume level of the speaker to equal the maximum volume level of the speaker; and
when the provisional volume level of the speaker is less than the minimum nonzero volume level of the speaker, setting the volume level of the speaker to equal the minimum nonzero volume level of the speaker.

2. The system of claim 1, wherein the operations further comprise:
when the selected volume level is zero, setting (214) the volume level of each speaker (102) of the plurality of speakers to equal zero.

3. The system of claim 1, wherein the speaker volume selector is configured to allow the selection of the selected volume level by allowing adjustment of a volume level by a volume step size.

4. The system of claim 3, wherein the plurality of volume offsets includes volume levels that differ by an integral multiple of the volume step size.

5. The system of claim 1, wherein setting the volume level of each speaker comprises generating a digital volume signal that includes information corresponding to the volume level of the speaker (102) and sending the digital volume signal to the speaker (102).

6. The system of claim 1, wherein a volume offset for at least one speaker (102) of the plurality of speakers is a positive quantity.

7. The system of claim 1, wherein a volume offset for at least one speaker (102) of the plurality of speakers is a negative quantity.

8. The system of claim 1, wherein a volume offset for at least one speaker (102) of the plurality of speakers is zero.

9. A method for controlling volume levels of a plurality of speakers (102), the method comprising:
displaying, on an electronic display screen (108), a speaker volume selector to receive input to select a volume level to set volume levels of the plurality of speakers (102);
receiving (204) a plurality of volume offsets corresponding to the plurality of speakers (102), at least two volume offsets of the plurality of volume offsets being different from each other;
in response to receiving the selected volume level at the speaker volume selector, for each speaker (102) of the plurality of speakers, when the selected volume level is greater than zero:
calculating (206) a provisional volume level for the speaker as being a sum of the selected volume level and the volume offset of the speaker;
comparing (208) the provisional volume level of the speaker to an operational range of volume levels for the speaker;
when the provisional volume level of the speaker is within the operational range of volume levels for the speaker, setting (210) a volume level of the speaker to equal the provisional volume level of the speaker; and
when the provisional volume level of the speaker is outside the operational range of volume levels for the speaker, setting (212) the volume level of the speaker to equal a value within the operational range of volume levels for the speaker; and
displaying, on the electronic display screen (108), the volume levels set for each of the speakers (102),
wherein the operational range of volume levels for the speaker (102) extends between a minimum nonzero volume level of the speaker and a maximum volume level of the speaker, inclusive, and
wherein the method further comprises, for each speaker (102) of the plurality of speakers, when the selected volume level is greater than zero:
when the provisional volume level of the speaker is greater than the maximum volume level of the speaker, setting the volume level of the speaker to equal the maximum volume level of the speaker; and
when the provisional volume level of the speaker is less than the minimum nonzero volume level of the speaker, setting the volume level of the speaker to equal the minimum nonzero volume level of the speaker.

10. The method of claim 9, further comprising:
when the selected volume level is zero, setting (214) the volume level of each speaker of the plurality of speakers to equal zero.

11. The method of claim 9, wherein the speaker volume selector allows the selection of the selected volume level by allowing adjustment of a volume level by a volume step size.

12. The method of claim 11, wherein the plurality of volume offsets includes volume levels that differ by an integral multiple of the volume step size.

13. A system (100) for controlling volume levels of a plurality of speakers (102), the system comprising:
a processor (104); and
memory (106) configured to store instructions that, when executed by the processor, cause the processor to execute operations, the operations comprising:
receiving (202) a selected volume level;
receiving (204) a plurality of volume offsets corresponding to the plurality of speakers (102), at least two volume offsets of the plurality of volume offsets being different from each other;
for each speaker (102) of the plurality of speakers, when the selected volume level is greater than zero:
calculating (206) a provisional volume level for the speaker as being a sum of the selected volume level and the volume offset of the speaker;
comparing (208) the provisional volume level of the speaker to an operational range of volume levels for the speaker;
when the provisional volume level of the speaker is within the operational range of volume levels for the speaker, setting (210) a volume level of the speaker to equal the provisional volume level of the speaker;
when the provisional volume level of the speaker is outside the operational range of volume levels for the speaker, setting (212) the volume level of the speaker to equal a value within the operational range of volume levels for the speaker; and
generating a digital volume signal that includes information corresponding to the volume level of the speaker; and
sending the digital volume signal to the speaker,
wherein the operational range of volume levels for the speaker (102) extends between a minimum nonzero volume level of the speaker (102) and a maximum volume level of the speaker (102), inclusive, and
wherein the operations further comprise, for each speaker (102) of the plurality of speakers, when the selected volume level is greater than zero:
when the provisional volume level of the speaker is greater than the maximum volume level of the speaker, setting the volume level of the speaker to equal the maximum volume level of the speaker; and
when the provisional volume level of the speaker is less than the minimum nonzero volume level of the speaker, setting the volume level of the speaker to equal the minimum nonzero volume level of the speaker.

14. The system of claim 13, wherein the operations further comprise:
when the selected volume level is zero, setting (214) the volume level of each speaker (102) of the plurality of speakers to equal zero.

## Patentansprüche

1. System (100) zum Steuern von Lautstärkepegeln mehrerer Lautsprecher (102), wobei das System Folgendes umfasst:
einen Prozessor (104); und
einen Speicher (106), der dazu konfiguriert ist, Anweisungen zu speichern, die, wenn sie von dem Prozessor ausgeführt werden, den Prozessor dazu veranlassen, Vorgänge auszuführen, wobei die Vorgänge Folgendes umfassen:
Anzeigen, auf einem elektronischen Anzeigebildschirm (108), eines Lautsprecherlautstärkewählers, um eine Eingabe zu empfangen, um einen Lautstärkepegel auszuwählen, um Lautstärkepegel der mehreren Lautsprecher (102) einzustellen;
Empfangen (204) von mehreren Lautstärke-Offsets, die den mehreren Lautsprechern (102) entsprechen, wobei sich mindestens zwei Lautstärke-Offsets der mehreren Lautstärke-Offsets voneinander unterscheiden;
als Reaktion auf das Empfangen des ausgewählten Lautstärkepegels an dem Lautsprecherlautstärkewähler, für jeden Lautsprecher (102) der mehreren Lautsprecher, wenn der ausgewählte Lautstärkepegel größer als null ist:
Berechnen (206) eines vorläufigen Lautstärkepegels für den Lautsprecher als eine Summe aus dem ausgewählten Lautstärkepegel und dem Lautstärke-Offset des Lautsprechers;
Vergleichen (208) des vorläufigen Lautstärkepegels des Lautsprechers mit einem Betriebsbereich von Lautstärkepegeln für den Lautsprecher;
wenn der vorläufige Lautstärkepegel des Lautsprechers innerhalb des Betriebsbereichs von Lautstärkepegeln für den Lautsprecher liegt, Einstellen (210) eines Lautstärkepegels des Lautsprechers auf gleich den vorläufigen Lautstärkepegel des Lautsprechers; und
wenn der vorläufige Lautstärkepegel des Lautsprechers außerhalb des Betriebsbereichs von Lautstärkepegeln für den Lautsprecher liegt, Einstellen (212) des Lautstärkepegels des Lautsprechers auf gleich einen Wert innerhalb des Betriebsbereichs von Lautstärkepegeln für den Lautsprecher; und
Anzeigen, auf dem elektronischen Anzeigebildschirm (108), der Lautstärkepegel, die für jeden der Lautsprecher (102) eingestellt wurden,
wobei sich der Betriebsbereich von Lautstärkepegeln für den Lautsprecher (102) zwischen einschließlich eines minimalen Lautstärkepegels, der nicht null ist, des Lautsprechers und eines maximalen Lautstärkepegels des Lautsprechers erstreckt und
wobei die Vorgänge ferner, für jeden Lautsprecher (102) der mehreren Lautsprecher, wenn der ausgewählte Lautstärkepegel größer als null ist, Folgendes umfassen:
wenn der vorläufige Lautstärkepegel des Lautsprechers größer als der maximale Lautstärkepegel des Lautsprechers ist, Einstellen des Lautstärkepegels des Lautsprechers auf gleich den maximalen Lautstärkepegel des Lautsprechers; und
wenn der vorläufige Lautstärkepegel des Lautsprechers geringer als der minimale Lautstärkepegel, der nicht null ist, des Lautsprechers ist, Einstellen des Lautstärkepegels des Lautsprechers auf gleich den minimalen Lautstärkepegel, der nicht null ist, des Lautsprechers.

2. System nach Anspruch 1, wobei die Vorgänge ferner Folgendes umfassen:
wenn der ausgewählte Lautstärkepegel null ist, Einstellen (214) des Lautstärkepegels jedes Lautsprechers (102) der mehreren Lautsprecher auf gleich null.

3. System nach Anspruch 1, wobei der Lautsprecherlautstärkewähler dazu konfiguriert ist, die Auswahl des ausgewählten Lautstärkepegels zu ermöglichen, indem eine Anpassung eines Lautstärkepegels um eine Lautstärkenstufengröße ermöglicht wird.

4. System nach Anspruch 3, wobei die mehreren Lautstärke-Offsets Lautstärkepegel beinhalten, die sich um ein ganzzahliges Vielfaches der Lautstärkenstufengröße unterscheiden.

5. System nach Anspruch 1, wobei das Einstellen des Lautstärkepegels jedes Lautsprechers Erzeugen eines digitalen Lautstärkesignals, das Informationen beinhaltet, die dem Lautstärkepegel des Lautsprechers (102) entsprechen, und Senden des digitalen Lautstärkesignals an den Lautsprecher (102) umfasst.

6. System nach Anspruch 1, wobei ein Lautstärke-Offset für mindestens einen Lautsprecher (102) der mehreren Lautsprecher eine positive Menge ist.

7. System nach Anspruch 1, wobei ein Lautstärke-Offset für mindestens einen Lautsprecher (102) der mehreren Lautsprecher eine negative Menge ist.

8. System nach Anspruch 1, wobei ein Lautstärke-Offset für mindestens einen Lautsprecher (102) der mehreren Lautsprecher null ist.

9. Verfahren zum Steuern von Lautstärkepegeln mehrerer Lautsprecher (102), wobei das Verfahren Folgendes umfasst:
Anzeigen, auf einem elektronischen Anzeigebildschirm (108), eines Lautsprecherlautstärkewählers, um eine Eingabe zu empfangen, um einen Lautstärkepegel auszuwählen, um Lautstärkepegel der mehreren Lautsprecher (102) einzustellen;
Empfangen (204) von mehreren Lautstärke-Offsets, die den mehreren Lautsprechern (102) entsprechen, wobei sich mindestens zwei Lautstärke-Offsets der mehreren Lautstärke-Offsets voneinander unterscheiden;
als Reaktion auf das Empfangen des ausgewählten Lautstärkepegels an dem Lautsprecherlautstärkewähler, für jeden Lautsprecher (102) der mehreren Lautsprecher, wenn der ausgewählte Lautstärkepegel größer als null ist:
Berechnen (206) eines vorläufigen Lautstärkepegels für den Lautsprecher als eine Summe aus dem ausgewählten Lautstärkepegel und dem Lautstärke-Offset des Lautsprechers;
Vergleichen (208) des vorläufigen Lautstärkepegels des Lautsprechers mit einem Betriebsbereich von Lautstärkepegeln für den Lautsprecher;
wenn der vorläufige Lautstärkepegel des Lautsprechers innerhalb des Betriebsbereichs von Lautstärkepegeln für den Lautsprecher liegt, Einstellen (210) eines Lautstärkepegels des Lautsprechers auf gleich den vorläufigen Lautstärkepegel des Lautsprechers; und
wenn der vorläufige Lautstärkepegel des Lautsprechers außerhalb des Betriebsbereichs von Lautstärkepegeln für den Lautsprecher liegt, Einstellen (212) des Lautstärkepegels des Lautsprechers auf gleich einen Wert innerhalb des Betriebsbereichs von Lautstärkepegeln für den Lautsprecher; und
Anzeigen, auf dem elektronischen Anzeigebildschirm (108), der Lautstärkepegel, die für jeden der Lautsprecher (102) eingestellt wurden,
wobei sich der Betriebsbereich von Lautstärkepegeln für den Lautsprecher (102) zwischen einschließlich eines minimalen Lautstärkepegels, der nicht null ist, des Lautsprechers und eines maximalen Lautstärkepegels des Lautsprechers erstreckt und
wobei das Verfahren ferner, für jeden Lautsprecher (102) der mehreren Lautsprecher, wenn der ausgewählte Lautstärkepegel größer als null ist, Folgendes umfasst:
wenn der vorläufige Lautstärkepegel des Lautsprechers größer als der maximale Lautstärkepegel des Lautsprechers ist, Einstellen des Lautstärkepegels des Lautsprechers auf gleich den maximalen Lautstärkepegel des Lautsprechers; und
wenn der vorläufige Lautstärkepegel des Lautsprechers geringer als der minimale Lautstärkepegel, der nicht null ist, des Lautsprechers ist, Einstellen des Lautstärkepegels des Lautsprechers auf gleich den minimalen Lautstärkepegel, der nicht null ist, des Lautsprechers.

10. Verfahren nach Anspruch 9, ferner umfassend:
wenn der ausgewählte Lautstärkepegel null ist, Einstellen (214) des Lautstärkepegels jedes Lautsprechers der mehreren Lautsprecher auf gleich null.

11. Verfahren nach Anspruch 9, wobei der Lautsprecherlautstärkewähler die Auswahl des ausgewählten Lautstärkepegels ermöglicht, indem eine Anpassung eines Lautstärkepegels um eine Lautstärkenstufengröße ermöglicht wird.

12. Verfahren nach Anspruch 11, wobei die mehreren Lautstärke-Offsets Lautstärkepegel beinhalten, die sich um ein ganzzahliges Vielfaches der Lautstärkenstufengröße unterscheiden.

13. System (100) zum Steuern von Lautstärkepegeln mehrerer Lautsprecher (102), wobei das System Folgendes umfasst:
einen Prozessor (104); und
einen Speicher (106), der dazu konfiguriert ist, Anweisungen zu speichern, die, wenn sie von dem Prozessor ausgeführt werden, den Prozessor dazu veranlassen, Vorgänge auszuführen, wobei die Vorgänge Folgendes umfassen:
Empfangen (202) eines ausgewählten Lautstärkepegels;
Empfangen (204) von mehreren Lautstärke-Offsets, die den mehreren Lautsprechern (102) entsprechen, wobei sich mindestens zwei Lautstärke-Offsets der mehreren Lautstärke-Offsets voneinander unterscheiden;
für jeden Lautsprecher (102) der mehreren Lautsprecher, wenn der ausgewählte Lautstärkepegel größer als null ist:
Berechnen (206) eines vorläufigen Lautstärkepegels für den Lautsprecher als eine Summe aus dem ausgewählten Lautstärkepegel und dem Lautstärke-Offset des Lautsprechers;
Vergleichen (208) des vorläufigen Lautstärkepegels des Lautsprechers mit einem Betriebsbereich von Lautstärkepegeln für den Lautsprecher;
wenn der vorläufige Lautstärkepegel des Lautsprechers innerhalb des Betriebsbereichs von Lautstärkepegeln für den Lautsprecher liegt, Einstellen (210) eines Lautstärkepegels des Lautsprechers auf gleich den vorläufigen Lautstärkepegel des Lautsprechers;
wenn der vorläufige Lautstärkepegel des Lautsprechers außerhalb des Betriebsbereichs von Lautstärkepegeln für den Lautsprecher liegt, Einstellen (212) des Lautstärkepegels des Lautsprechers auf gleich einen Wert innerhalb des Betriebsbereichs von Lautstärkepegeln für den Lautsprecher; und
Erzeugen eines digitalen Lautstärkesignals, das Informationen beinhaltet, die dem Lautstärkepegel des Lautsprechers entsprechen; und
Senden des digitalen Lautstärkesignals an den Lautsprecher,
wobei sich der Betriebsbereich von Lautstärkepegeln für den Lautsprecher (102) zwischen einschließlich eines minimalen Lautstärkepegels, der nicht null ist, des Lautsprechers (102) und eines maximalen Lautstärkepegels des Lautsprechers (102) erstreckt und
wobei die Vorgänge ferner, für jeden Lautsprecher (102) der mehreren Lautsprecher, wenn der ausgewählte Lautstärkepegel größer als null ist, Folgendes umfassen:
wenn der vorläufige Lautstärkepegel des Lautsprechers größer als der maximale Lautstärkepegel des Lautsprechers ist, Einstellen des Lautstärkepegels des Lautsprechers auf gleich den maximalen Lautstärkepegel des Lautsprechers; und
wenn der vorläufige Lautstärkepegel des Lautsprechers geringer als der minimale Lautstärkepegel, der nicht null ist, des Lautsprechers ist, Einstellen des Lautstärkepegels des Lautsprechers auf gleich den minimalen Lautstärkepegel, der nicht null ist, des Lautsprechers.

14. System nach Anspruch 13, wobei die Vorgänge ferner Folgendes umfassen:
wenn der ausgewählte Lautstärkepegel null ist, Einstellen (214) des Lautstärkepegels jedes Lautsprechers (102) der mehreren Lautsprecher auf gleich null.

## Revendications

1. Système (100) de commande des niveaux de volume d'une pluralité de haut-parleurs (102), le système comprenant :
un processeur (104) ; et
une mémoire (106) configurée pour stocker des instructions qui, lorsqu'elles sont exécutées par le processeur, amènent le processeur à exécuter des opérations, les opérations comprenant :
afficher, sur un écran d'affichage électronique (108), un sélecteur de volume de haut-parleur pour recevoir une entrée afin de sélectionner un niveau de volume pour définir les niveaux de volume de la pluralité de haut-parleurs (102) ;
recevoir (204) une pluralité de décalages de volume correspondant à la pluralité de haut-parleurs (102), au moins deux décalages de volume de la pluralité de décalages de volume étant différents l'un de l'autre ;
en réponse à l'étape consistant à recevoir le niveau de volume sélectionné au niveau du sélecteur de volume de haut-parleur, pour chaque haut-parleur (102) de la pluralité de haut-parleurs, lorsque le niveau de volume sélectionné est supérieur à zéro :
calculer (206) un niveau de volume provisoire pour le haut-parleur comme étant une somme du niveau de volume sélectionné et du décalage de volume du haut-parleur ;
comparer (208) le niveau de volume provisoire du haut-parleur à une plage de fonctionnement de niveaux de volume pour le haut-parleur ;
lorsque le niveau de volume provisoire du haut-parleur est au sein de la plage de fonctionnement de niveaux de volume pour le haut-parleur, définir (210) un niveau de volume du haut-parleur comme étant égal au niveau de volume provisoire du haut-parleur ; et
lorsque le niveau de volume provisoire du haut-parleur est à l'extérieur de la plage de fonctionnement de niveaux de volume pour le haut-parleur, définir (212) le niveau de volume du haut-parleur comme étant égal à une valeur au sein de la plage de fonctionnement de niveaux de volume pour le haut-parleur ; et
afficher, sur l'écran d'affichage électronique (108), des niveaux de volume définis pour chacun des haut-parleurs (102),
dans lequel la plage de fonctionnement de niveaux de volume pour le haut-parleur (102) s'étend entre un niveau de volume non nul minimal du haut-parleur et un niveau de volume maximal du haut-parleur, inclus, et
dans lequel les opérations comprennent en outre, pour chaque haut-parleur (102) de la pluralité de haut-parleurs, lorsque le niveau de volume sélectionné est supérieur à zéro :
lorsque le niveau de volume provisoire du haut-parleur est supérieur au niveau de volume maximal du haut-parleur, définir le niveau de volume du haut-parleur comme étant égal au niveau de volume maximal du haut-parleur ; et
lorsque le niveau de volume provisoire du haut-parleur est inférieur au niveau de volume non nul minimal du haut-parleur, définir le niveau de volume du haut-parleur comme étant égal au niveau de volume non nul minimal du haut-parleur.

2. Système selon la revendication 1, dans lequel les opérations comprennent en outre les étapes consistant à :
lorsque le niveau de volume sélectionné est nul, définir (214) le niveau de volume de chaque haut-parleur (102) de la pluralité de haut-parleurs comme étant égal à zéro.

3. Système selon la revendication 1, dans lequel le sélecteur de volume de haut-parleur est configuré pour permettre la sélection du niveau de volume sélectionné en permettant l'ajustement d'un niveau de volume d'une taille de pas de volume.

4. Système selon la revendication 3, dans lequel la pluralité de décalages de volume inclut des niveaux de volume qui diffèrent d'un multiple entier de la taille de pas de volume.

5. Système selon la revendication 1, dans lequel l'étape consistant à définir le niveau de volume de chaque haut-parleur comprend une étape consistant à générer un signal de volume numérique qui inclut des informations correspondant au niveau de volume du haut-parleur (102) et envoyer le signal de volume numérique au haut-parleur (102).

6. Système selon la revendication 1, dans lequel un décalage de volume pour au moins un haut-parleur (102) de la pluralité de haut-parleurs est une quantité positive.

7. Système selon la revendication 1, dans lequel un décalage de volume pour au moins un haut-parleur (102) de la pluralité de haut-parleurs est une quantité négative.

8. Système selon la revendication 1, dans lequel un décalage de volume pour au moins un haut-parleur (102) de la pluralité de haut-parleurs est zéro.

9. Procédé de commande des niveaux de volume d'une pluralité de haut-parleurs (102), le procédé comprenant les étapes consistant à :
afficher, sur un écran d'affichage électronique (108), un sélecteur de volume de haut-parleur pour recevoir une entrée afin de sélectionner un niveau de volume pour définir les niveaux de volume de la pluralité de haut-parleurs (102) ;
recevoir (204) une pluralité de décalages de volume correspondant à la pluralité de haut-parleurs (102), au moins deux décalages de volume de la pluralité de décalages de volume étant différents l'un de l'autre ;
en réponse à l'étape consistant à recevoir le niveau de volume sélectionné au niveau du sélecteur de volume de haut-parleur, pour chaque haut-parleur (102) de la pluralité de haut-parleurs, lorsque le niveau de volume sélectionné est supérieur à zéro :
calculer (206) un niveau de volume provisoire pour le haut-parleur comme étant une somme du niveau de volume sélectionné et du décalage de volume du haut-parleur ;
comparer (208) le niveau de volume provisoire du haut-parleur à une plage de fonctionnement de niveaux de volume pour le haut-parleur ;
lorsque le niveau de volume provisoire du haut-parleur est au sein de la plage de fonctionnement de niveaux de volume pour le haut-parleur, définir (210) un niveau de volume du haut-parleur comme étant égal au niveau de volume provisoire du haut-parleur ; et
lorsque le niveau de volume provisoire du haut-parleur est à l'extérieur de la plage de fonctionnement de niveaux de volume pour le haut-parleur, définir (212) le niveau de volume du haut-parleur comme étant égal à une valeur au sein de la plage de fonctionnement de niveaux de volume pour le haut-parleur ; et
afficher, sur l'écran d'affichage électronique (108), des niveaux de volume définis pour chacun des haut-parleurs (102),
dans lequel la plage de fonctionnement de niveaux de volume pour le haut-parleur (102) s'étend entre un niveau de volume non nul minimal du haut-parleur et un niveau de volume maximal du haut-parleur, inclus, et
dans lequel le procédé comprend en outre, pour chaque haut-parleur (102) de la pluralité de haut-parleurs, lorsque le niveau de volume sélectionné est supérieur à zéro :
lorsque le niveau de volume provisoire du haut-parleur est supérieur au niveau de volume maximal du haut-parleur, définir le niveau de volume du haut-parleur comme étant égal au niveau de volume maximal du haut-parleur ; et
lorsque le niveau de volume provisoire du haut-parleur est inférieur au niveau de volume non nul minimal du haut-parleur, définir le niveau de volume du haut-parleur comme étant égal au niveau de volume non nul minimal du haut-parleur.

10. Procédé selon la revendication 9, comprenant en outre les étapes consistant à :
lorsque le niveau de volume sélectionné est nul, définir (214) le niveau de volume de chaque haut-parleur de la pluralité de haut-parleurs comme étant égal à zéro.

11. Procédé selon la revendication 9, dans lequel le sélecteur de volume de haut-parleur permet la sélection du niveau de volume sélectionné en permettant l'ajustement d'un niveau de volume d'une taille de pas de volume.

12. Procédé selon la revendication 11, dans lequel la pluralité de décalages de volume inclut des niveaux de volume qui diffèrent d'un multiple entier de la taille de pas de volume.

13. Système (100) de commande des niveaux de volume d'une pluralité de haut-parleurs (102), le système comprenant :
un processeur (104) ; et
une mémoire (106) configurée pour stocker des instructions qui, lorsqu'elles sont exécutées par le processeur, amènent le processeur à exécuter des opérations, les opérations comprenant :
recevoir (202) un niveau de volume sélectionné ;
recevoir (204) une pluralité de décalages de volume correspondant à la pluralité de haut-parleurs (102), au moins deux décalages de volume de la pluralité de décalages de volume étant différents l'un de l'autre ;
pour chaque haut-parleur (102) de la pluralité de haut-parleurs, lorsque le niveau de volume sélectionné est supérieur à zéro :
calculer (206) un niveau de volume provisoire pour le haut-parleur comme étant une somme du niveau de volume sélectionné et du décalage de volume du haut-parleur ;
comparer (208) le niveau de volume provisoire du haut-parleur à une plage de fonctionnement de niveaux de volume pour le haut-parleur ;
lorsque le niveau de volume provisoire du haut-parleur est au sein de la plage de fonctionnement de niveaux de volume pour le haut-parleur, définir (210) un niveau de volume du haut-parleur comme étant égal au niveau de volume provisoire du haut-parleur ;
lorsque le niveau de volume provisoire du haut-parleur est à
l'extérieur de la plage de fonctionnement de niveaux de volume pour le haut-parleur, définir (212) le niveau de volume du haut-parleur comme étant égal à une valeur au sein de la plage de fonctionnement de niveaux de volume pour le haut-parleur ; et générer un signal de volume numérique qui inclut des informations
correspondant au niveau de volume du haut-parleur ; et envoyer le signal de volume numérique au haut-parleur,
dans lequel la plage de fonctionnement de niveaux de volume pour le haut-parleur (102) s'étend entre un niveau de volume non nul minimal du haut-parleur (102) et un niveau de volume maximal du haut-parleur (102), inclus, et
dans lequel les opérations comprennent en outre, pour chaque haut-parleur (102) de la pluralité de haut-parleurs, lorsque le niveau de volume sélectionné est supérieur à zéro :
lorsque le niveau de volume provisoire du haut-parleur est supérieur au niveau de volume maximal du haut-parleur, définir le niveau de volume du haut-parleur comme étant égal au niveau de volume maximal du haut-parleur ; et
lorsque le niveau de volume provisoire du haut-parleur est inférieur au niveau de volume non nul minimal du haut-parleur, définir le niveau de volume du haut-parleur comme étant égal au niveau de volume non nul minimal du haut-parleur.

14. Système selon la revendication 13, dans lequel les opérations comprennent en outre les étapes consistant à :
lorsque le niveau de volume sélectionné est nul, définir (214) le niveau de volume de chaque haut-parleur (102) de la pluralité de haut-parleurs comme étant égal à zéro.
